**Europäisches Patentamt**

**European Patent Office**

**Office européen des brevets**

(11) Publication number: **0 095 879**

**B1**

(12) EUROPEAN PATENT SPECIFICATION

(45) Date of publication of patent specification: **19.08.87**

(51) Int. Cl.⁴: **H 01 J 27/02, H 01 J 37/08**

(21) Application number: **83302940.8**

(22) Date of filing: **23.05.83**

(54) Apparatus and method for working surfaces with a low energy high intensity ion beam.

<table>
<tr><td>

(30) Priority: **01.06.82 US 383919**

(43) Date of publication of application:
**07.12.83 Bulletin 83/49**

(45) Publication of the grant of the patent:
**19.08.87 Bulletin 87/34**

(84) Designated Contracting States:
**DE FR GB IT**

(56) References cited:
**FR-A-2 490 399**
**US-A-3 388 291**
**US-A-3 969 646**

**SOVIET PHYSICS TECHNICAL PHYSICS, vol. 51, no. 3, March 1981, pages 304-315, American Institute of Physics, New York, US; A.M. DORODNOV et al.: "Physical principles and types of technological vacuum plasma devices"**

</td><td>

(73) Proprietor: **International Business Machines Corporation**
**Old Orchard Road**
**Armonk, N.Y. 10504 (US)**

(73) Proprietor: **Kaufman, Harold Richard**
**401, Spinnaker**
**Fort Collins Colorado 80525 (US)**

(72) Inventor: **Kaufman, Harold Richard**
**401 Spinnaker**
**Fort Collins Colorado 80525 (US)**
Inventor: **Cuomo, Jerome John**
**P.O. Box 353**
**Lincolndale New York 10540 (US)**

(74) Representative: **Carpmael, John William Maurice et al**
**CARPMAELS & RANSFORD 43 Bloomsbury Square**
**London, WC1A 2RA (GB)**

(56) References cited:
**SOVIET PHYSICS TECHNICAL PHYSICS, vol. 23, no. 9, September 1978, pages 1055-1057, American Institute of Physics, New York, US; A.M. BISHAEV et al.: "Local plasma properties in a Hall-current accelerator with an extended acceleration zone"**

</td></tr>
</table>

## Description

The present invention relates to integrated circuit fabrication techniques using ion beam bombardment of a substrate. Specifically, method and apparatus are provided for generating low energy, high intensity ion beams for various manufacturing processes of the integrated circuit art.

The working of substrate surfaces using ion bombardment is well known in the art. High energy ion bombardment of substrates in order to sputter atomic particles from a target has been successful to etch substrate surfaces. Alternatively the sputtered particles may be deposited through a mask to form circuit components in a deposition process.

Typically ion beams used in these known processes are high energy, low density beams which because of their high kinetic energy upon impact with a substrate surface produce an undesirable space charge at the target surface. Various techniques have been employed to neutralize the space charge which interferes with normal ion bombardment of the substrate. These techniques employ the addition of neutralizing electrons to the ion beam for neutralizing the undesired space charge.

Prior art high current ion beam generators typically employ accelerator grids to extract the ions from a generator. The grids maintain an electrostatic charge which accelerates ions at the plasma sheath boundary towards the target. The grids themselves are however subject to sputtering from the escaping ions. The result is damage to the grids as well as the addition of impurities to the ion stream which are a source of contamination for the substrate. The grids are typically maintained at voltage potentials which accelerate only ions. The free charged particles, electrons in the case of a positive ion beam, which are available for neutralizing the ion beam, must be added to the ions after acceleration.

The presence of accelerator grids for producing the ion beam also imposes a well known limitation on the ion beam current capacity. By limiting the number of accelerator grids to one, such as is described in U.S. Patent 4,259,145, and reducing the thickness of the accelerator grid, the current limitations can be partially offset. This unfortunately results in a very thin and hence fragile screen grid.

A further disadvantage of the higher energy ion beams is encountered during certain processes such as substrate cleaning when it is desirable to remove a thin oxide layer from the substrate before subjecting the substrate to bombardment. The higher energy beams will result in undesirable and excessive damage of underlying material during the oxide removing process step.

Other known techniques for generating an ion beam include the use of a plasma diode for generating low energy ions beams. This technique has the disadvantage of being located in close proximity to the surface being bombarded.

Energetic electrons which sustain the plasma are capable of interacting with the surface being processed. Further, the trajectory of exiting ions is dependent on local surface variations of the sheath making control over the ion beam direction difficult.

US—A—3 388 291 (Cann) discloses a Hall current generator apparatus for electromagnetically accelerating and confirming an ionised gas plasma.

US—A—3 707 304 (Basset et al) discloses a magnetic lens, for focussing a beam of charged particles, which includes a coil at least part of which, at an end thereof, tapers conically with a half-angle between 20° and 85°.

US—A—4 277 304 (Horiike et al) discloses an ion source suitable for use in an etching process involved in the manufacture of e.g. semiconductor devices. The ion source comprises an anode disposed in a vacuum chamber, a box-type cathode opposite the anode, and one or more permanent magnets forming a magnetic field at right angles to the electric field between the anode and cathode. The shape of the magnet in the box-type cathode may be varied, for instance it may be cylindrical, rectangular or labyrinthine, but in each case the sides of the magnet are parallel.

US—A—4 361 472 (Morrison, Jr), discloses a method and apparatus for sputtering an element with a magnetron plasma source where a plasma is formed between two electrostatic field defining surfaces of the source, and a generator anode disposed adjacent the plasma ejects it toward the element to be sputtered. The specification discloses various arrangements in which the angular orientation of the cathode or pseudo-cathode surfaces is variable. It also discloses the use of shaped magnets, but these are used to change the shape of the magnetic field outside the plasma generating area.

The object of the present invention is to provide an apparatus and method for producing a high intensity low energy ion beam of controlled beam width and which is diverging or focussed depending on the particular process application for which it is intended without utilizing accelerator grids.

These objects are accomplished by the apparatus and method as defined in the appended claims. Low energy, high intensity ion beams are formed using a Hall current ion source, which produces either a diverging beam or focussed beam depending upon the particular process application for the ion beam. The resulting beam is used in certain steps to remove oxides from a substrate, or effect reactive etching and direct deposition on certain type of substrates.

A Hall current ion source suitable for use in working the surfaces of electronic component substrates is provided with direct control over the generated ion beam. The ion source includes a plasma generator open at one end to emit low energy high intensity ions. First and second magnetic pole pieces are located inside the plasma generator. The magnetic pole pieces increase the collisions of gas molecules with high energy electrons generated by the anode and cathode elements of the plasma chamber. The field of the magnetic pole pieces also interact with an electron current to produce the electrostatic field that accelerates the ions. Additionally, the pole pieces are arranged at an acute angle with each other to form either a diverging or converging ion beam.

The ion beam generated by apparatus in accordance with the invention does not require an accelerator grid to provide an electrostatic field for accelerating the ions outside the plasma chamber thus avoiding the disadvantages inherent with gridded accelerators. Ion acceleration takes place near the exit aperture of the ion source due to the presence of a cathode element external to the exit aperture. The magnetic flux lines between poles pieces represent substantially equal potential contours in the acceleration region. Therefore, by selectively arranging the pole pieces at an angle with respect to each other, the magnetic lines between pole pieces establish controlled trajectories from ions accelerated under the influence of the external cathode.

The present invention will now be described, by way of example only, with reference to the accompanying drawings, in which:

Figure 1a is a sectional view of a conventional Hall ion source;

Figure 1b is a sectional view of a Hall source having an additional electrode for reducing sputtering damage;

Figure 2 is a graph demonstrating the voltage potential distribution within the Hall ion source;

Figure 3 is a sectional view of one embodiment of an ion source according to the invention having a focused ion beam;

Figure 4 is a sectional view of another embodiment of an ion source according to the invention wherein a diverging ion beam is formed;

Figure 5a is a sectional view of yet another embodiment of an ion source according to the invention wherein a diverging ion beam is formed; and

Figure 5b illustrates the apparatus of Figure 5a with additional electrodes for reducing sputtering damage.

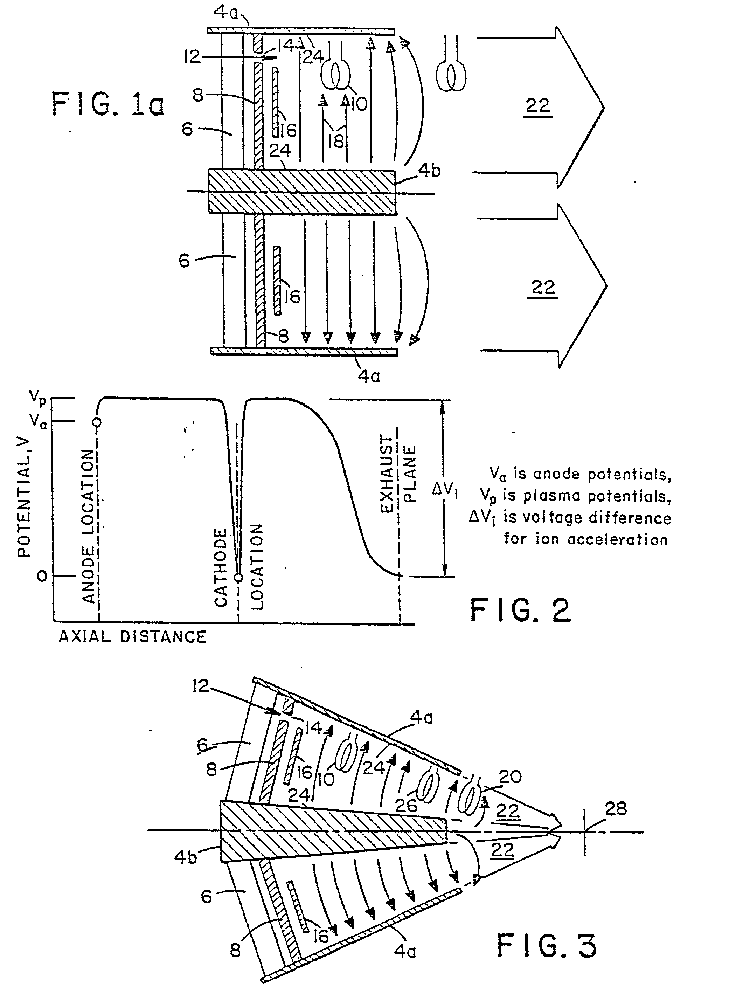

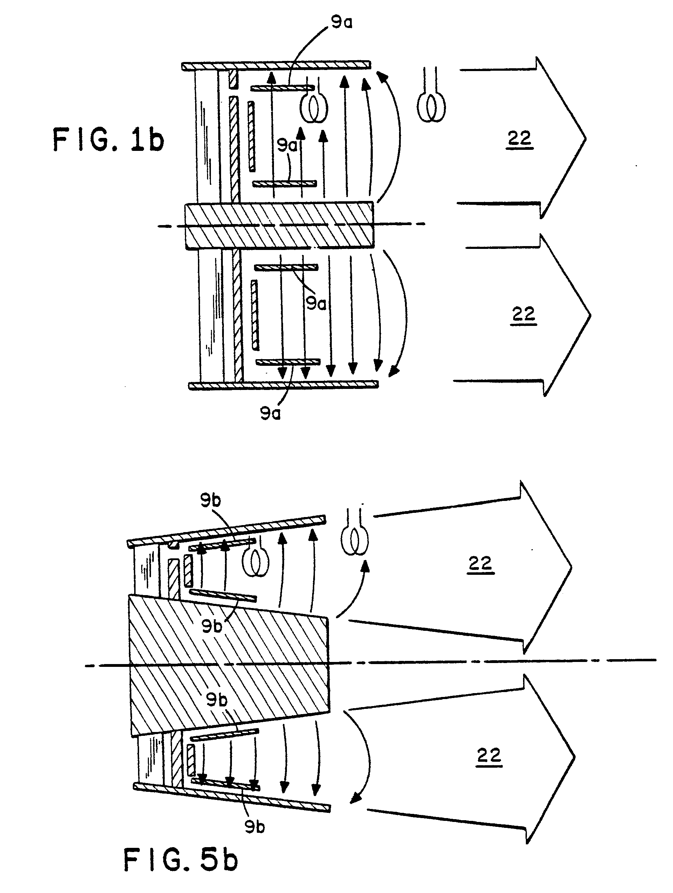

Referring now to Figure 1a, there is shown a Hall current ion generator of the prior art. The generator comprises an inner pole piece 4b and an outer pole piece 4a circumferentially enclosing the inner pole piece 4b. The pole pieces are made of a permeable material such as soft iron polarized by one or more magnets 6. A partition member 8 seals one end of the ion source and includes an aperture 12 for permitting an ionizing gas such as argon to enter the chamber defined by the outer pole piece 4a. The opposite end of the ion chamber is open to permit ions formed within the chamber to exit.

Located within the chamber formed by circumferentially extending pole piece 4a is a circumferentially extending anode 16. Electrical connections are made to the anode 16 to permit a voltage potential to be applied thereto from outside the ion source.

Additional to the anode 16 is a cathode member 10 spaced apart from the anode 16 towards the exit opening of the ion source. The cathode 10 is similarly connected externally to a source of voltage potential more negative than the potential applied to anode 16.

Pole pieces 4b and 4a create magnetic lines of force 18 as shown in Figure 1. Those lines of force near the exit end of the ion source extend in an arcuate manner between pole pieces.

Referring to Figure 2, the potential. profile within the ion source of Figure 1a is shown. The anode is located at a positive potential Va and the cathode is at zero volts potential with respect to the anode potential. The voltage potential Va is typically 50 volts. A plasma is formed in a manner to be explained within the ion source and within the ion generation region near the anode it has a potential slightly positive of the anode potential.

The decrease in potential near the exit plane of the ion source is demonstrated in Figure 2. The decrease in voltage potential, which provides for an ion acceleration zone, is provided for by an external filament (cathode) 20 which may be maintained at the potential of cathode 10, or more negative, up to several hundred volts negative of cathode 10. The cooperation of the magnetic field from pole pieces 4a and 4b with the electron current produced by filament (cathode) 20 produces the required trajectories for ions exiting from the source and forming a beam 22. The shape of the magnetic field lines can be used to control the trajectory of the departing ions. Within the chamber the magnetic field lines are nearly radial and the acceleration tends to be axial in direction. Acceleration within the arcuate fringe field near the exit of the chamber results in more divergent ion trajectories.

Ion generation occurs within the ion generator as electrons which are emitted from the internal cathode 10 migrate towards the anode 16. The resulting plasma includes ions, low energy secondary electrons, and a few high energy primary electrons. The magnetic field produced within the ion source of Figure 1 increases the path length of the migrating electrons whereby collisions between electrons and gas molecules are increased enriching the ion content of the plasma. Also produced as a result of the collisions between gas molecules and electrons emitted by the cathode 10 are low energy secondary electrons. The pressure within the ion source is maintained at typically 133 Pa (1 Torr). With the plasma potential typically several volts positive of the anode 16, the escape rate of electrons to the anode is at a rate consistent with the discharge current and ion beam current. In many applications, the cathode is maintained at approximately 30 to 50 volts negative of the anode.

The conductivity of the plasma within the Hall current source is much higher along the magnetic field lines than across them. Therefore, to a close approximation the magnetic field lines within the acceleration region represent equal potential contours and therefore determine the trajectories of the accelerated ions.

Local plasma potential in the ion beam 22 is determined by the filament 20 which acts as a second cathode. The electrostatic field formed between the plasma near the anode 16 and filament (cathode) 20 is normal to the magnetic field, and ions escape under the influence of said electrostatic field in an axial direction away from the ion source. The filament (cathode) 20 also emits electrons which move towards the anode 16. In moving toward the anode 16, interactions with the magnetic field will impart an azimuthal motion to the electrons emitted by filament (cathode) 20. The azimuthal motion of the electrons which enter the plasma constitute a Hall current. The electron current from filament (cathode) 20 to anode 16 places an additional current load on the voltage source between the two, thereby reducing the efficiency of the acceleration process. The added electrical power required due to the reduced efficiency is seldom a serious consideration in sputtering and deposition applications. Further, an ion source of the Hall current type produces ions which have a larger energy spread than results in other types of ion generators. However, in some of the applications to be discussed this energy spread is not of consequence. The filament (cathode) 20 also supplies neutralizing electrons to the ion beam.

The ion source of Figure 1a uses two cathodes, cathode 10, and filament 20. It is possible to operate a Hall current ion source with only filament (cathode) 20. Ions are produced in this mode of operation from the filament (cathode) 20 becoming negative of anode 16 by more than the ionization potential.

Incidental to the ejection of ions from the exit aperture of the ion source, are collisions with the surfaces 24 of the outer pole piece 4a and the center pole piece 4b. Both a loss of energetic ions and the sputtering of contamination particles occur as a result of these surface collisions. As is known to those skilled in the art, these collisions and the resulting sputtering of surfaces 24 can be reduced by the use of additional electrodes 9a, as indicated in Figure 1b. The additional electrodes 9a are nonmagnetic, hence do not affect the magnetic field. The electrodes 9a, do, however, serve to confine the ion generation to a portion of the chamber volume removed from surfaces 24. When the ions are accelerated in an axial direction, the probability of collision with surfaces 24 is therefore greatly reduced when electrodes 9a are used. The electrodes 9a are typically operated near the potential of cathode 10 to prevent the rapid escape of energetic electrons.

The aforesaid Hall current source can provide for a variety of industrial applications of high density, low energy beam of ions. The Hall current source can be used in processes for cleaning whereby thin layers of oxides and other materials may be removed from surfaces of workpieces with little or no sputtering of the underlying surface. Further, since the ion source does not require a grid at the exit aperture, contamination of the ion beam is maintained at a minimum level. Thus, the ion source for use as a neutralizer to introduce electrons into yet another ion beam is attractive because of the low contamination contained in the Hall current source produced ion beam.

In reactive etching techniques known to those skilled in the art, specific chemical compounds result when a specific reactive species of a particle is contained within the ion beam. Thus, the principal agent for removing particles is not through the use of high kinetic energy ions to bombard or sputter a surface, but is through a low kinetic energy ion beam which reacts with a surface thus, selectively working the surface. The use of a Hall current ion sources provides for a high density beam of low energy ions which will not result in physical sputtering, but will permit the more selective reactive etching to take place.

Finally, the Hall current source is useful in direct deposition techniques where materials are deposited on a substrate from an incident ion beam. Deposition rates obtained in the prior art processes have been low due to the requirement that the ions have a low incident ion kinetic energy to avoid excessive sputter removal of previously deposited materials. The Hall current source has the ability to accelerate a high density current of low energy ions which avoids the sputter removal associated with other techniques which do not provide adequate control over the kinetic energy of incident ions.

An apparatus in accordance with one embodiment of the invention which facilitates the use of the Hall current type ion source with these techniques is shown more particularly in Figure 3. Figure 3 represents an apparatus having a focusing arrangement for focusing a Hall current source ion beam on a specific target 28. As before, the Hall current ion source includes pole pieces 4a and 4b. However, the pole pieces 4a and 4b are conical and converge towards a point 28 which is coincident with the target substrate. Thus, the point of convergence identifies the focus point for the Hall current ion source of Figure 3. The convergence of the ion beam results from the circular magnetic field lines produced by the conical pole pieces with a common vertex. The normal electrostatic field produced between filament (cathode) 20 and the plasma near the anode 16 will in cooperation with the circular magnetic field lines focus the ion beam at the vertex of the pole pieces 4a, 4b.

As in the previous ion source, there exists an aperture 14 for permitting entry of the gas to be ionized to the ion source. Cathode 10 and filament (cathode) 20 and anode 16 provide the necessary flow of electrons which under the influence of magnetic field 18 result in ion collisions with the gas molecules. Also as in the previous ion source, the conductivity of the plasma within the Hall current ion source is much higher along the magnetic field lines than across them. Therefore, to a close approximation the magnetic field lines within the acceleration region again represent equal potential contours and can therefore determine the trajectories of the accelerated ions. The magnetic field will produce some deflections of the ion trajectories, but this effect is usually small. By reducing the magnitude of the magnetic field strength, the acceleration efficiency will be reduced as a result of more diffusion of electrons from the filament (cathode) 20 in a direction opposite to the ion acceleration path, but the secondary effects on the ion trajectories will also be reduced. Further, the truncation of the pole pieces 4a and 4b at their ends remote from the anode 16 to form the exit aperture of the ion source will influence the ion trajectories away from the ideal, i.e. convergence at the geometric point of convergence of pole pieces. The secondary effects of truncation on the trajectories of departing ions will, of course, depend on the extend of the fringe magnetic field traversed by the ions near the exit aperture of the ion source. In order to decrease even further the secondary effects of this truncation on the trajectories, a third cathode 26 is inserted between cathode 10 and filament (cathode) 20. The region between cathode 26 and the exit aperture thereby becomes for the ions an equipotential drift space reducing the electron emission current required from filament (cathode) 20. Filament (cathode) 20 may remain in place as a source of neutralization particles for the ion beam. If filament (cathode) 20 is removed, neutralization may still be accomplished by third cathode 26 if the strength and extent of the magnetic field between filament (cathode) 20 and third cathode 26 are not too large.

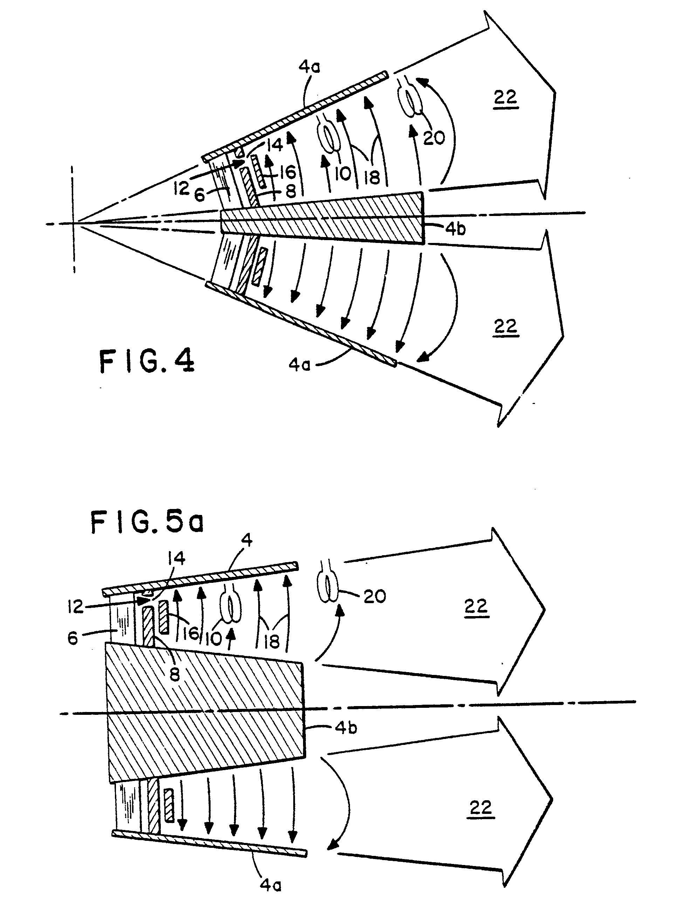

Figure 4 represents yet another embodiment of the invention, for producing a diverging ion beam. In the configuration shown in Figure 4, the exit aperture is defined by the wider ends of diverging pole pieces 4a and 4b. The generation of ions, and control of their trajectories is similar to the embodiment of Figure 3. A divergent beam is desirable for many cleaning and deposition applications where it is necessary to cover a wide surface area. The converging beam is more appropriate for deposition applications in which the sputtering is produced from an intense ion beam on a small target area. The small target area permits reduced fixturing size and volume, and also permits the use of close spacings and high deposition rates.

Figure 5a represents yet another embodiment of the invention, wherein a third category of ion beam coverage is obtained. With the center pole piece 4b constructed as shown as a cone, it is possible to obtain a more complete coverage at the expense of decreased uniformity for the ion current density. At a distance away from the ion source exit aperture, the beam spreads out sufficiently to include the axis of the source. However, the increased coverage near the axis is compromised by a decreased uniformity in the spread ion beam.

Figure 5b demonstrates the use of additional electrode element 9b for reducing the sputtering damage due to ion collisions with the magnetic pole pieces 4a, 4b. These additional electrode elements can, of course, be implemented in any of the embodiments described herein.

## Claims

1. An apparatus for producing a self neutralized beam of ions comprising:
   an elongate plasma chamber;
   an inlet (14) for introducing a plasma-forming gas into the plasma chamber;
   a first magnetic pole piece (4b) of circular cross-section extending axially within the plasma chamber;
   a second magnetic pole piece (4a) of annular cross-section surrounding the first pole piece (4b) for establishing a substantially radial magnetic field (18) between the pole pieces (4a, 4b);
   an electron source (10 or 20); and
   an anode (16) located adjacent one end of the magnetic pole pieces (4a, 4b) for receiving a voltage potential such that electrons from the source (10, 20) are drawn towards the anode (16) through the plasma in between the magnetic poles pieces (4a, 4b);
   characterised in that:
   the radial separation between the first and second pole pieces (4a, 4b) decreases along the length thereof.

2. An apparatus according to claim 1, wherein the electron source is a cathode (20) located outside the magnetic poles pieces (4a, 4b).

3. An apparatus according to claim 2, and including a further cathode (10) located inside the magnetic pole pieces (4a, 4b).

4. An apparatus according to claim 4, and including a third cathode (26) located inside the magnetic pole pieces (4a, 4b).

5. An apparatus according to claim 1, wherein the electron source is a cathode (10) located inside the magnetic pole pieces (4a, 4b).

6. An apparatus according to any one of claims 2 to 5, wherein each cathode (10, 20 or 26) comprises a filament.

7. An apparatus according to any one of claims 1 to 6, wherein the inlet (14) is located adjacent the anode (16).

8. An apparatus according to any one of claims 1 to 7, wherein the anode (16) circumferentially surrounds a part of the first magnetic pole piece 4b adjacent the one end thereof.

9. An apparatus according to any one of claims 1 to 8, and including sputtering reducing electrodes (9b) within the magnetic pole pieces (4a, 4b).

10. An apparatus according to any one of claims 1 to 9, wherein the radial separation increases in the direction away from the anode (16).

11. An apparatus according to any one of claims 1 to 9, wherein the radial separation decreases in the direction away from the anode (16).

12. An apparatus according to any one of claims 1 to 11, wherein each magnetic pole piece (4a or 4b) has a truncated conical cross section.

13. A process for cleaning, etching, or depositing material on, a substrate, comprising:

generating a high density, low energy beam of appropriate ions in an apparatus according to any one of claims 1 to 12; and

directing the beam of ions onto the substrate to cause removal of contaminants from, removal of particles from or deposition of ions on, said substrate.

**Patentansprüche**

1. Verfahren zur Erzeugung eines selbstneutralisierten Ionenstrahls

mit einer langgestreckten Plasmakammer;

einem Einlaß (14) zur Einführung eines plasmabildenden Gases in die Plasmakammer;

einem ersten Magnetpolschuh (4b) kreisförmigen Querschnitts, welcher sich axial innerhalb der Plasmakammer erstreckt;

einem den ersten Polschuh (4b) umgebenden zweiten Magnetpolschuh (4a) ringförmigem Querschnitts zur Errichtung eines im wesentlichen radialen Magnetfeldes (18) zwischen den Polschuhen (4a, 4b);

einer Elektronenquelle (10 oder 20); und

einer benachbart zu einem Ende der Magnetpolschuhe (4a, 4b) angeordneten Anode (16) zur Annahme eines Spannungspotentials derart, daß Elektronen aus der Quelle (10, 20) durch das Plasma zwischen den Magnetpolschuhen (4a, 4b) zur Anode (16) gezogen werden,

dadurch gekennzeichnet, daß

der radiale Abstand zwischen dem ersten und dem zweiten Polschuh (4a, 4b) längs deren Länge abnimmt.

2. Vorrichtung nach Anspruch 1, bei welcher die Elektronenquelle eine außerhalb der Magnetpolschuhe (4a, 4b) angeordnete Kathode (20) ist.

3. Vorrichtung nach Anspruch 2, die auch eine innerhalb der Magnetpolschuhe (4a, 4b) angeordnete weitere Kathode (10) enthält.

4. Vorrichtung nach Anspruch 3, die auch eine innerhalb der Magnetpolschuhe (4a, 4b) angeordnete dritte Kathode (26) enthält.

5. Vorrichtung nach Anspruch 1, bei welcher die Elektronenquelle eine innerhalb der Magnetpolschuhe (4a, 4b) angeordnete Kathode (10) ist.

6. Vorrichtung nach iregendeinem der Ansprüche 2 bis 5, bei welcher jede Kathode (10, 20 oder 26) einen Faden umfaßt.

7. Vorrichtung nach irgendeinem der Ansprüche 1 bis 6, bei welcher der Einlaß (14) benachbart zur Anode (16) angeordnet ist.

8. Vorrichtung nach irgendeinem der Ansprüche 1 bis 7, bei welcher die Anode (16) einen zu einem Ende desselben benachbarten Teil des ersten Magnetpolschuhes (4b) umfänglich umgibt.

9. Vorrichtung nach irgendeinem der Ansprüche 1 bis 8, die auch Sputterverminderungselektroden (9b) innerhalb der Magnetpolschuhe (4a, 4b) enthält.

10. Vorrichtung nach irgendeinem der Ansprüche 1 bis 9, bei welcher der radiale Abstand in Richtung weg von der Anode (16) zunimmt.

11. Vorrichtung nach irgendeinem der Ansprüche 1 bis 9, bei welcher der radiale Abstand in Richtung weg von der Anode (16) abnimmt.

12. Vorrichtung nach irgendeinem der Ansprüche 1 bis 11, bei welcher jeder Magnetpolschuh (4a, oder 4b) einen kegelstumpfförmigen Querschnitt hat.

13. Verfahren zur Reinigung, Ätzung oder Abscheidung von Material auf einem Substrat, welches

das Erzeugen eines Strahls hoher Dichte und niedriger Energie geeigneter Ionen in einer Vorrichtung nach irgendeinem der Ansprüche 1 bis 12, und

das Richten des Ionenstrahls auf das Substrat zur Bewirkung einer Beseitigung von Verunreinigungen von, einer Beseitigung von Teilchen von oder einer Abscheidung von Ionen auf dem Substrat umfaßt.

**Revendications**

1. Appareil pour produire un faisceau auto-neutralisé d'ions comprenant: une chambre allongée à plasma; une entrée (14) pour introduire dans la chambre à plasma un gaz pouvant former un plasma; une première pièce polaire magnétique (4b) ayant en section une forme circulaire et s'étendant axialement à l'intérieur de la chambre à plasma; une seconde pièce polaire magnétique (4a) ayant en section une forme annulaire, entourant la première pièce polaire (4b) pour établir un champ magnétique (18) à peu près radial entre les pièces polaires (4a, et 4b); une source (10 ou 20) d'électrons; et une anode (16) disposée adjacente à une extrémité des pièces polaires magnétiques (4a, 4b) pour recevoir un potentiel de tension tel que des électrons provenant de la source (10, 20) sont attirés vers l'anode (16) à travers le plasma compris entre les pièces polaires magnétiques (4a, 4b), caractérisé en ce que la distance radiale entre la première et la seconde pièces polaires (4a, 4b) diminue suivant leur longueur.

2. Appareil suivant la revendication 1, dans lequel la source d'électrons est une cathode (20) disposée à l'extérieur des pièces polaires magnétiques (4a, 4b).

3. Appareil suivant la revendication 2, comprenant une autre cathode (10) disposée à l'intérieur des piècs polaires magnétiques (4a, 4b).

4. Appareil suivant la revendication 4, comprenant une troisième cathode (26) disposée à l'intérieur des pièces polaires magnétiques (4a, 4b).

5. Appareil suivant la revendication 1, dans lequel la source d'électrons est une cathode (10) disposée à l'intérieur des piècs polaires magnétiques (4a, 4b).

6. Appareil suivant l'une quelconque des revendications 2 à 5, dans lequel chaque cathode (10, 20, ou 26) est constituée par un filament.

7. Appareil suivant l'une quelconque des revendications 1 à 6, dans lequel l'entrée (14) est située au voisinage de l'anode (16).

8. Appareil suivant l'une quelconque des revendications 1 à 7, dans lequel l'anode (16) entoure circonférentielement une partie de la première pièce polaire magnétique (4b) au voisinage d'une extrémité de celle-ci.

9. Appareil suivant l'une quelconque des revendications 1 à 8, comprenant des électrodes (9b) réduisant la pulvérisation, à l'intérieur des pièces polaires magnétiques (4a, 4b).

10. Appareil suivant l'une quelconque des revendications 1 à 9, dans lequel la distance radiale augmente dans la direction s'éloignant de l'anode (16).

11. Appareil suivant l'une quelconque des revendications 1 à 9, dans lequel la distance radiale diminue dans le sens s'éloignant de l'anode (16).

12. Appareil suivant l'une quelconque des revendications 1 à 11, dans lequel chaque pièce polaire magnétique (4a ou 4b) présente en section une forme conique tronquée.

13. Procédé pour nettoyer, décaper, ou déposer de la matière sur un substrat, suivant lequel: on engendre un faisceau d'ions appropriée à basse énergie et à haute densité dans un appareil suivant l'une quelconque des revendications 1 à 12, et on dirige le faisceau d'ions sur le substrat pour provoquer l'enlèvement des contaminants, l'enlèvement de particules dudit substrat ou le dépôt d'ions sur celui-ci.

**0 095 879**

FIG. 1a

FIG. 2

$V_a$ is anode potentials,
$V_p$ is plasma potentials,
$\Delta V_i$ is voltage difference
for ion acceleration

FIG. 3

1

FIG. 1b

FIG. 5b

FIG. 4

FIG. 5a